# EUROPEAN PATENT SPECIFICATION

(11) **EP 1 225 582 B1**
(45) Date of publication and mention of the grant of the patent: **16.04.2014**
(21) Application number: 01306331.8
(22) Date of filing: 24.07.2001
(51) Int. Cl.: G11B 20/18, G11B 27/24, G11B 27/36, G11B 7/0037, G11B 7/005, H03L 7/06, G11B 7/007, G11B 20/10

(54) **Apparatus and method for detecting wobble defects**
Vorrichtung und Verfahren zur Erkennung von Wobble-Defekten
Appareil et procédé de détection de défauts d'oscillations

(30) Priority: 04.01.2001 KR 2001000368
(43) Date of publication of application: 24.07.2002
(73) Proprietor: Samsung Electronics Co., Ltd., Suwon-si, Gyeonggi-do, 443-742 (KR)
(72) Inventor: Eom, Woo-sik. 914-1501 Pyuckjeokgol 9-danji Jugong, Suwon-si, Gyeonggi-do (KR)
(74) Representative: Robinson, Ian Michael

(56) References cited:
- EP-A- 0 866 455
- EP-A- 0 945 866
- EP-A- 0 951 012
- EP-A- 0 967 612
- GB-A- 2 087 628
- US-A- 5 126 690
- US-A- 5 363 360
- US-A- 5 508 985
- US-A- 6 081 490

## Description

The present invention relates to an optical recording medium, and more particularly, to an apparatus and method for detecting wobble defects using a wobble signal detected from an optical recording medium having a wobble pattern.

Several types of optical disks such as the Digital Versatile Disk - Random Access Memory (DVD-RAM), DVD-Recordable (DVD-R), DVD-Rewritable (DVD-RW), and DVD+RW have been developed to date. A wobble pattern is present at a boundary region of a land and a groove in an optical recording medium. Thus, if numerous errors occur in the wobble pattern, there is a high probability that errors are present in data regions on lands and grooves.

Furthermore, a wobble signal according to a wobble pattern may be used in recording position information on an optical disk. Also, the wobble signal may be used as a reference clock for detecting a record/playback position or as a reference signal for generating the reference clock. Thus, a wobble signal according to a wobble pattern present on an optical recording medium is very important in the use of optical recording medium.

EP-A-0967612 mentions an optical disk recording apparatus including a wobble PLL detection circuit. This document teaches the prevention of erroneous recording due to failure of the wobble PLL clock which may occur when the wobble signal fails while data is being recorded on a predetermined region of a sector. The claims have been characterised with respect to this document.

US5,126,690 mentions a phase lock detector circuit for detecting the lock state of a phase locked loop (PLL) such that it is known when a synthesized clock has achieved a stable phase relationship with its reference clock signal.

With a view to solve or reduce the above problems, it is an aim of embodiments of the present invention to provide an apparatus and method for detecting a defect in a wobble pattern using a wobble signal detected from an optical recording medium, by which verification is performed on a corresponding defective region if a defect exists in the wobble pattern when recording data on the optical recording medium.

According to the present invention there is provided an apparatus and method as set forth in the appended claims. Preferred features of the invention will be apparent from the dependent claims, and the description which follows.

For a better understanding of the invention, and to show how embodiments of the same may be carried into effect, reference will now be made, by way of example, to the accompanying diagrammatic drawings in which:
Figure 1 is a function block diagram of a wobble defect detecting apparatus according to an embodiment of the present invention;
Figure 2 is a detailed block diagram of the phase-locked loop (PLL) of Figure 1;
Figure 3 is a timing diagram of the operation of the apparatus of Figure 1;
Figure 4 shows an example of the wobble lock/unlock detector of Figure 1; and
Figure 5 shows an example of the wobble defect detector of Figure 1.

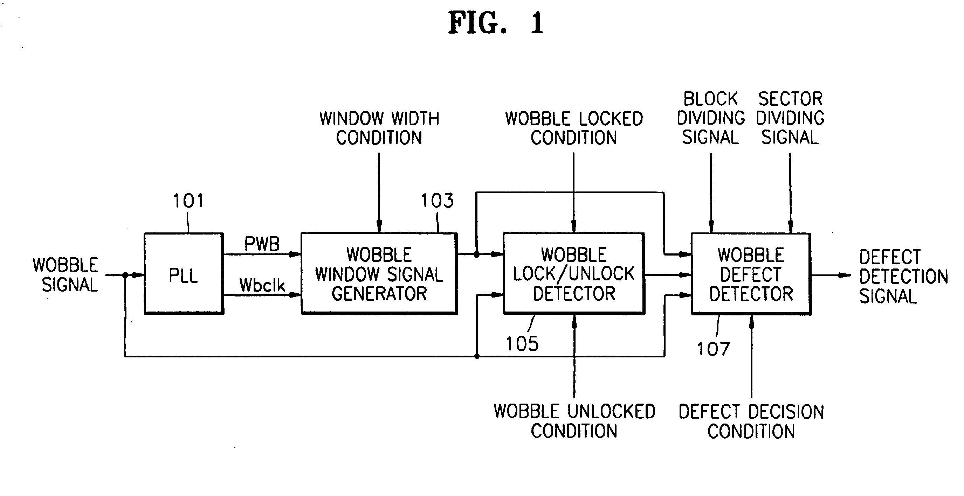

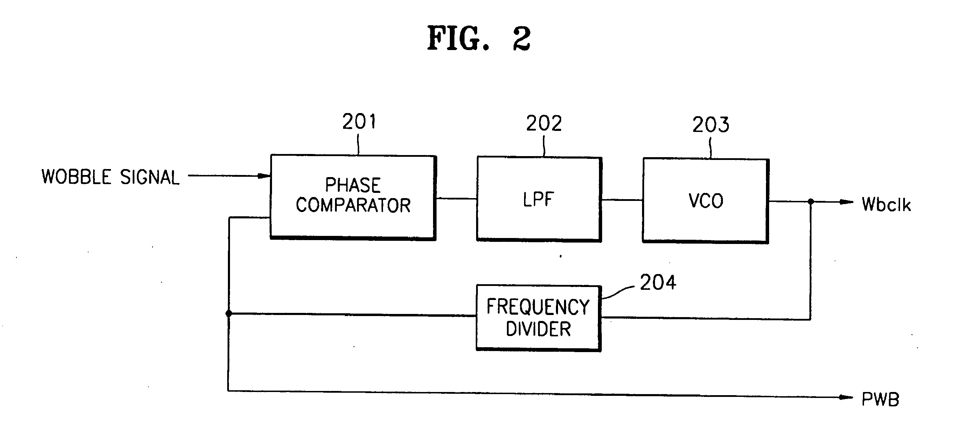

Referring to Figure 1, an apparatus for detecting a wobble defect according to the present invention includes a phase-locked loop (PLL) 101, a wobble window signal generator 103, a wobble lock/unlock detector 105, and a wobble defect detector 107. When a wobble signal is applied from an optical recording medium (not shown) through a radio frequency amplifier (RF-AMP) (not shown), the PLL 101 outputs a wobble clock signal Wbclk corresponding to a playback clock signal or a channel clock signal and a phase-locked looped signal PWB using the applied wobble signal. As shown in Figure 2, the PLL 101 includes a phase comparator 201, a low-pass filter LPF 202, a voltage controlled oscillator (VCO) 203, and a frequency divider 204.

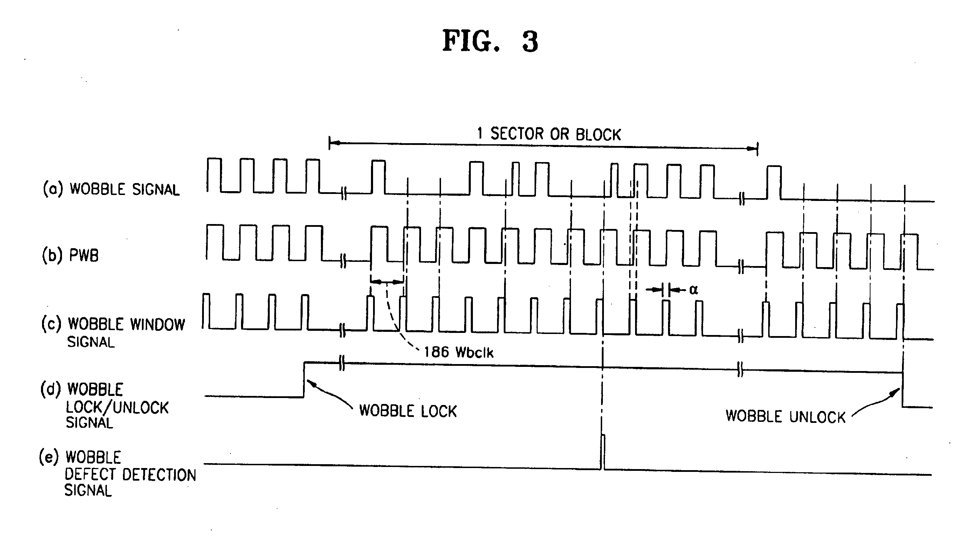

That is, when a wobble signal is applied with a period as shown in Figure 3(a), the phase comparator 201 compares the phase of the applied wobble signal with the phase of a phase-locked looped wobble signal PWB generated by dividing the frequency of the wobble clock signal Wbclk by 186 and outputs the comparison result. The LPF 202 filters out a high frequency component output from the phase comparator 201 and transmits the result to the VCO 203. The VCO 203 outputs a frequency corresponding to a voltage filtered by the LPF 202. That is, the VCO 203 outputs a frequency corresponding to a phase difference between the wobble signal and the phase-locked looped wobble signal. The wobble clock signal Wbclk is transmitted to the wobble window signal generator 103 and the frequency divider 204. The frequency divider 204 outputs the phase-locked looped wobble signal PWB obtained by dividing the wobble clock signal Wbclk by 186 to the phase comparator 201 and the wobble window signal generator 103. In this case, the output phase-locked looped wobble signal PWB has a period as shown in Figure 3(b) with respect to the applied wobble signal.

The wobble window signal generator 103 generates a wobble window signal having a window width condition based on the phase-locked looped wobble signal PWB applied thereto. That is, the window width condition refers to the number of wobble clock signals Wbclk. For example, if the window width condition is set to 10 and set based on the rising edge of the phase-locked looped wobble signal PWB as shown in Figure 3 (c), a period during which 10 wobble clock signals Wbclk are generated from the rising edge of the phase-locked looped wobble signal PWB corresponds to a state in which the wobble window signal is active ("high" state in Figure 3 (c)). The period is the width of the wobble window signal. In this case, the window width condition is provided from a system controller (not shown) or a microcomputer (micom) and set such that noise such as jitter of a wobble signal can be accounted for.

When the wobble window signal and the wobble signal are applied, the wobble lock/unlock detector 105 detects whether a locked or an unlocked state is set for the wobble signal depending on preset wobble locked and unlocked conditions. That is, if there are successive detections that a wobble signal exists, when an interval where the wobble window signal is high and the number of this detection satisfies the preset wobble locked condition, a signal for setting a wobble locked state is generated as shown in Figure 3 (d). On the other hand, if there are successive detections that no wobble signal exist, when the wobble window signal is high and the number of this detection satisfies the preset wobble unlocked condition, a signal for setting a wobble unlocked state is generated as shown in Figure 3 (d).

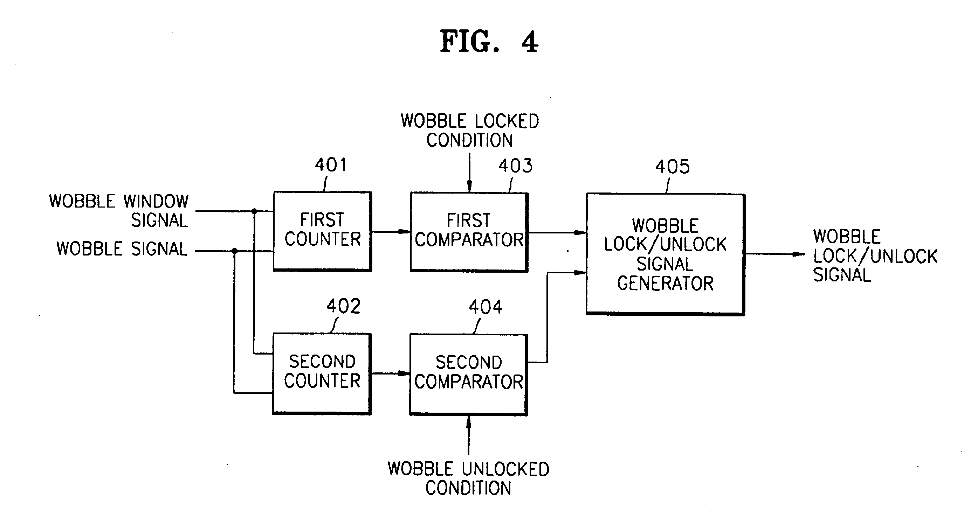

Referring to Figure 4, which shows an example of the wobble lock/unlock detector 105, the wobble lock/unlock detector 105 includes a first counter 401, a second counter 402, a first comparator 403, a second comparator 404, and a wobble lock/unlock signal generator 405. If a wobble signal exists when the wobble window signal is high, the first counter 401 counts up or down the number of wobble window signals. However, if a wobble signal does not exist when the wobble window signal is high, the first counter 401 is reset or cleared. The count value from the first counter 401 is output to the first comparator 403. The first comparator 403 compares the count value with a preset wobble locked condition. The wobble locked condition refers to the number at which the wobble signal is detected successively, which is provided from the system controller. For example, assuming that the wobble locked condition is set to '3' and the first counter 401 is an up counter, if the count value provided from the first counter 401 is 3, the first comparator 403 outputs a signal requesting generation of a signal indicative of a wobble locked state to the wobble lock/unlock signal generator 405.

If a wobble signal does not exist when the wobble window signal is high, the second counter 402 counts up or down the number of the wobble signals. Conversely, if a wobble signal exists when the wobble window signal is high exists, the second counter 402 is reset or cleared. The count value from the second counter 402 is output to the second comparator 404. The second comparator 404 compares the count value provided from the second counter 402 with a preset wobble unlocked condition. The wobble unlock condition refers to the number at which a wobble signal is not detected during successive detections, which is provided from the system controller. For example, assuming that the wobble unlocked condition is set to '4' and the second counter 402 is an up counter, if the count value provided from the second counter 402 is '4', the second comparator 404 outputs a signal requesting generation of a signal indicative of a wobble unlock state to the wobble lock/unlock signal generator 405. The wobble locked and unlocked conditions may be set to the same value.

The wobble lock/unlock signal generator 405 generates a signal as shown in Figure 3 (d) depending on the comparison results provided from the first and second comparators 403 and 404.

When the wobble window signal, the window lock/unlock signal, and the wobble signal are applied, if the number at which a wobble signal is not detected during the wobble window period for each block or sector during a wobble lock period satisfies a defect decision condition, the wobble defect detector 107 recognizes this as a wobble defect to output a wobble defect detection signal as shown in Figure 3 (e). The defect decision condition refers to the number at which a wobble signal is not detected. For example, if the defect decision is set to '5', if the number at which a wobble signal is not detected during a wobble window period for each block or sector is 5, the wobble defect detector 107 outputs a defect detection signal indicating that a wobble defect occurs in a corresponding block or sector. The defect decision condition is provided from the system controller. A block dividing signal and a sector dividing signal are provided by a control signal such as an encoder/decoder block or sector sync signal generated by a decoder (not shown) or an encoder (not shown) in an optical recording medium drive (or a driver). However, in the case of an optical recording medium in which sectors cannot be distinguished, a block dividing signal is provided from a decoder, but a sector dividing signal is provided by a control signal from an encoder such as a sector sync signal.

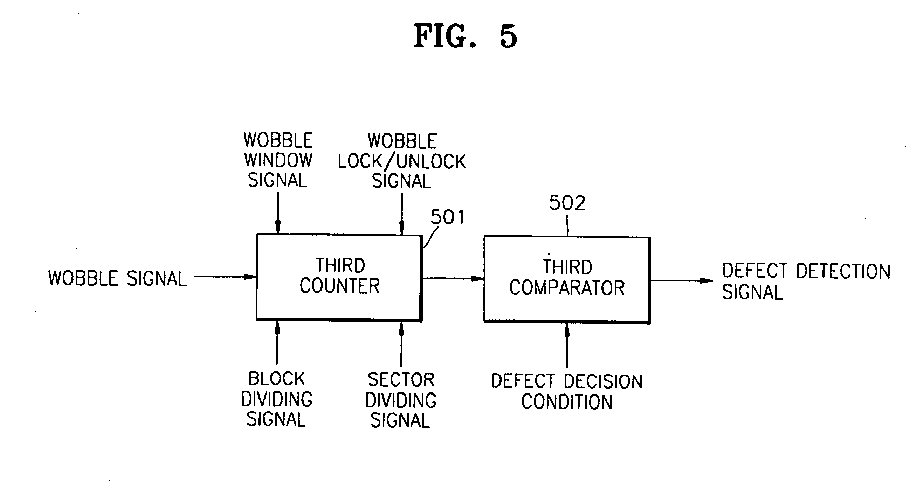

Referring to Figure 5, showing an example of the wobble defect detector 107 of Figure 1, the wobble defect detector 107 includes a third counter 501 and a third comparator 502. The third counter 501 is reset or cleared by a block dividing signal and a sector dividing signal, and a period during which the number of wobble window signals is actually counted, is set by a wobble lock/unlock signal. If a wobble signal does not exist during a wobble window period in a wobble locked state, the third counter 501 counts up or down the number of the wobble window signals. The count result from the third counter 501 is output to the third comparator 502. Assuming that the third counter 501 is an up counter and a defect decision condition is set to '5',if the count value provided from the third counter 501 is '5',the third comparator 502 outputs a defect detection signal.

The defect detection signal is provided to the system controller. When the defect detection signal is applied, the system controller recognizes this as an occurrence of a defect in a wobble pattern of a corresponding block or sector, and performs a verification process on data recorded on the corresponding block or sector. If the verification result is not satisfactory, data may be rewritten to the corresponding block or sector or data of the corresponding block or sector may be rewritten to a different region.

The logic state of each signal in this invention will not be limited by the above particular embodiment. That is, the logic state of each signal may be set differently. For example, although an active state of the wobble window signal has been set at a "high level" in the particular embodiment, the active state may be set at a "low level".

According to the present invention, if a defect is present in a wobble pattern within a sector or block on an optical recording medium having a predetermined wobble pattern during a recording operation, the verification of error is performed on data recorded on the sector or block in which a defect is present, thereby minimizing data loss due to recording of data on a defect region.

While this invention has been particularly shown and described with reference to a preferred embodiment thereof, it will be understood by those skilled in the art that various changes in form and details may be made therein without departing from the scope of the invention as defined by the appended claims.

## Claims

1. An apparatus for detecting a defect in a wobble signal obtained from a wobble pattern present at a boundary region of a land and a groove in an optical recording medium, the apparatus comprising:
a phase-locked loop (101) arranged to receive the wobble signal and to generate and output a wobble clock signal;
a wobble lock/unlock detector (105) arranged to receive the wobble signal and to output a signal detecting an unlocked state; and
a wobble defect detector (107) arranged to receive the signal detecting the wobble unlocked state and to detect whether any defect exists;
wherein the phase-locked loop (101) is further arranged to generate a phase-locked loop wobble signal by frequency dividing the wobble clock signal;
wherein a window signal generator (103) is arranged to receive the wobble clock signal and to generate a wobble window signal having a width set according to a predetermined window width condition, said window width condition defining a wobble window period according to a number of wobble clock signals; and
wherein the wobble lock/unlock detector (105) is further arranged to receive the wobble window signal and to output a signal detecting one of wobble locked and unlocked states depending on predetermined wobble locked and unlocked conditions, wherein the wobble unlocked condition is set by counting the number of consecutive times that no wobble signal is detected during the wobble window period;
**characterised in that**:
the phase-locked loop (101) is arranged to output the phase-locked loop wobble signal;
the window signal generator (103) is arranged to receive the phase-locked loop wobble signal to generate the wobble window signal based on the phase-locked loop wobble signal
the wobble lock/unlock detector (105) determines the wobblelocked condition by counting the number of consecutive times that the wobble signal is detected during the wobble window period, and
the wobble defect detector (107) is arranged to receive the wobble window signal and the wobblesignal in order to detect whether any defect exists in the wobble pattern depending on a predetermined defect decision condition; wherein the predetermined defect decision condition is set considering a number of non-detections of a wobble signal during the wobble window period in the wobble locked state.

2. The apparatus of any preceding claim, wherein the wobble defect detector (107) detects whether the defect exists for each block or sector.

3. The apparatus of any preceding claim, wherein the wobble lock/unlock detector (105) comprises:
a first counter (401) adapted to count the number of the wobble window signals if the wobble signal is not present during the wobble window period and to be reset or cleared if a wobble signal does not exist during the same period;
a first comparator (403) adapted to compare the count result from the first counter with the wobble locked condition and to request a wobble locked condition if the counted result satisfies the wobble locked condition;
a second counter (402) adapted to count the number of the wobble window signals if a wobble signal does not exist during the wobble window period and to be reset or cleared if the wobble signal exists during the same interval; and
a second comparator (404) adapted to compare the count result from the second counter with the wobble unlocked condition and to request a wobble unlocked state if the counted result satisfies the wobble unlock condition; and
a wobble lock/unlock signal generator (405) adapted to output a signal indicative of the wobble locked/unlocked state depending on the outputs from the first and second comparators.

4. The apparatus of any preceding claim, wherein the wobble defect detector comprises:
a third counter (501) adapted to count the number of the wobble window signals if a wobble signal is not present during the wobble window period in a wobble locked state; and
a third comparator (502) adapted to compare a count value output from the third counter with the predetermined detect decision condition and to output a signal indicative of defect detection if the count value satisfies the defect decision condition.

5. A method for detecting a defect in a wobble signal obtained from a wobble pattern present at a boundary region of a land and a groove in an optical recording medium, the method comprising:
phase locking the wobble signal in a phase-locked loop and generating a wobble clock signal;
detecting a wobble locked or unlocked state depending on predetermined wobble unlocked conditions; and
generating a defect detection signal;
generating a phase-locked loop wobble signal by frequency dividing the wobble clock signal;
using the wobble clock signal to generate a wobble window signal having a width set according to a predetermined window width condition, said window width condition defining a wobble window period according to a number of wobble clock signals;
detecting a wobble unlocked state depending on the presence of a wobble signal during a wobble window period set by the wobble window signalwherein the wobble unlocked condition is set counting the number of consecutive times that no wobble signal is detected during the wobble window period; and
**characterised by**:
generating the wobble window signal based on the phase-locked loop wobble signal;
determining the wobble locked condition by counting the number of consecutive times that the wobble signal is detected during the wobble window period, and
generating a defect detection signal when the presence of the wobble signal during the wobble window signal in a wobble locked state satisfies a predetermined defect decision condition, wherein the predetermined defect decision condition is set considering a number of non-detections of a wobble signal during the wobble window period in the wobble locked state.

## Patentansprüche

1. Vorrichtung zum Detektieren eines Defekts in einem Wobbelsignal, das aus einem Wobbelmuster erhalten wurde, das in einer Grenzregion einer Erhöhung und einer Vertiefung in einem optischen Aufzeichnungsmedium vorhanden ist, wobei die Vorrichtung Folgendes umfasst:
einen Phasenregelkreis (101), der dafür ausgelegt ist, das Wobbelsignal zu empfangen und ein Wobbeltaktsignal zu generieren und auszugeben;
einen Wobbelverriegelungs-/-entriegelungsdetektor (105), der dafür ausgelegt ist, das Wobbelsignal zu empfangen und ein Signal auszugeben, das einen entriegelten Zustand detektiert; und
einen Wobbeldefektdetektor (107), der dafür ausgelegt ist, das Signal zu empfangen, das den entriegelten Wobbelzustand detektiert, und zu detektieren, ob ein Defekt vorliegt;
wobei der Phasenregelkreis (101) des Weiteren dafür ausgelegt ist, durch Frequenzteilung des Wobbeltaktsignals ein Phasenregelkreis-Wobbelsignal zu generieren;
wobei ein Fenstersignalgenerator (103) dafür ausgelegt ist, das Wobbeltaktsignal zu empfangen und ein Wobbelfenstersignal zu generieren, das eine Breite aufweist, die gemäß einer zuvor festgelegten Fensterbreitenbedingung eingestellt ist, wobei die Fensterbreitenbedingung einen Wobbelfensterzeitraum gemäß einer Anzahl von Wobbeltaktsignalen definiert; und
wobei der Wobbelverriegelungs-/- entriegelungsdetektor (105) des Weiteren dafür ausgelegt ist, das Wobbelfenstersignal zu empfangen und ein Signal auszugeben, das in Abhängigkeit von zuvor festgelegten verriegelten und entriegelten Wobbelbedingungen einen verriegelten oder einen entriegelten Wobbelzustand detektiert, wobei die entriegelte Wobbelbedingung durch Zählen der Anzahl von aufeinanderfolgenden Malen, die während des Wobbelfensterzeitraums kein Wobbelsignal detektiert wird, eingestellt wird;
**dadurch gekennzeichnet, dass**:
der Phasenregelkreis (101) dafür ausgelegt ist, das Phasenregelkreis-Wobbelsignal auszugeben;
der Fenstersignalgenerator (103) dafür ausgelegt ist, das Phasenregelkreis-Wobbelsignal zu empfangen, um das Wobbelfenstersignal auf der Grundlage des Phasenregelkreis-Wobbelsignals zu generieren;
der Wobbelverriegelungs-/-entriegelungsdetektor (105) die verriegelte Wobbelbedingung durch Zählen der Anzahl von aufeinanderfolgenden Malen, die das Wobbelsignal während des Wobbelfensterzeitraums detektiert wird, bestimmt, und
der Wobbeldefektdetektor (107) dafür ausgelegt ist, das Wobbelfenstersignal und das Wobbelsignal zu empfangen, um in Abhängigkeit von einer zuvor festgelegten Defektentscheidungsbedingung zu detektieren, ob in dem Wobbelmuster ein Defekt vorliegt, wobei die zuvor festgelegte Defektentscheidungsbedingung unter Berücksichtigung einer Anzahl von Nichtdetektionen eines Wobbelsignals während des Wobbelfensterzeitraums in dem verriegelten Wobbelzustand eingestellt wird.

2. Vorrichtung nach einem der vorangehenden Ansprüche, wobei der Wobbeldefektdetektor (107) detektiert, ob der Defekt für jeden Block oder Sektor vorliegt.

3. Vorrichtung nach einem der vorangehenden Ansprüche, wobei der Wobbelverriegelungs-/- entriegelungsdetektor (105) Folgendes umfasst:
einen ersten Zähler (401), der dafür geeignet ist, die Anzahl der Wobbelfenstersignale zu zählen, wenn das Wobbelsignal während des Wobbelfensterzeitraums nicht vorhanden ist, und zurückgesetzt oder gelöscht zu werden, wenn kein Wobbelsignal während desselben Zeitraums vorhanden ist;
einen ersten Komparator (403), der dafür geeignet ist, das Zählergebnis aus dem ersten Zähler mit der verriegelten Wobbelbedingung zu vergleichen und eine verriegelte Wobbelbedingung anzufordern, wenn das gezählte Ergebnis die verriegelte Wobbelbedingung erfüllt;
einen zweiten Zähler (402), der dafür geeignet ist, die Anzahl der Wobbelfenstersignale zu zählen, wenn während des Wobbelfensterzeitraums kein Wobbelsignal vorhanden ist, und zurückgesetzt oder gelöscht zu werden, wenn das Wobbelsignal während desselben Intervalls vorliegt; und
einen zweiten Komparator (404), der dafür geeignet ist, das Zählergebnis aus dem zweiten Zähler mit der entriegelten Wobbelbedingung zu vergleichen und einen entriegelten Wobbelzustand anzufordern, wenn das gezählte Ergebnis die entriegelte Wobbelbedingung erfüllt; und
einen Wobbelverriegelungs-/-entriegelungs-Signalgenerator (405), der dafür geeignet ist, ein Signal, das für den Wobbelverriegelungs-/- entriegelungszustand in Abhängigkeit von den Ausgangssignalen aus dem ersten und dem zweiten Komparator steht, auszugeben.

4. Vorrichtung nach einem der vorangehenden Ansprüche, wobei der Wobbeldefektdetektor Folgendes umfasst:
einen dritten Zähler (501), der dafür geeignet ist, die Anzahl der Wobbelfenstersignale zu zählen, wenn kein Wobbelsignal während des Wobbelfensterzeitraums in einem verriegelten Wobbelzustand vorhanden ist; und
einen dritten Komparator (502), der dafür geeignet ist, einen aus dem dritten Zähler ausgegebenen Zählwert mit der zuvor festgelegten Detektionsentscheidungsbedingung zu vergleichen und ein Signal auszugeben, das für eine Defektdetektion steht, wenn der Zählwert die Defektentscheidungsbedingung erfüllt.

5. Verfahren zum Detektieren eines Defekts in einem Wobbelsignal, das aus einem Wobbelmuster erhalten wurde, das in einer Grenzregion einer Erhöhung und einer Vertiefung in einem optischen Aufzeichnungsmedium vorhanden ist, wobei das Verfahren Folgendes umfasst:
Phasenverriegeln des Wobbelsignals in einem Phasenregelkreis und Generieren eines Wobbeltaktsignals;
Detektieren eines verriegelten oder entriegelten Wobbelzustands in Abhängigkeit von zuvor festgelegten entriegelten Wobbelbedingungen; und
Generieren eines Defektdetektionssignals;
Generieren eines Phasenregelkreis-Wobbelsignals durch Frequenzteilung des Wobbeltaktsignals;
Verwenden des Wobbeltaktsignals zum Generieren eines Wobbelfenstersignals, das eine Breite aufweist, die gemäß einer zuvor festgelegten Fensterbreitenbedingung eingestellt ist, wobei die Fensterbreitenbedingung einen Wobbelfensterzeitraum gemäß einer Anzahl von Wobbeltaktsignalen definiert;
Detektieren eines entriegelten Wobbelzustands in Abhängigkeit vom Vorliegen eines Wobbelsignals während eines durch das Wobbelfenstersignal eingestellten Wobbelfensterzeitraums, wobei die entriegelte Wobbelbedingung durch Zählen der Anzahl von aufeinanderfolgenden Malen, die kein Wobbelsignal während des Wobbelfensterzeitraums detektiert wird, eingestellt wird; und
**gekennzeichnet durch**:
Generieren des Wobbelfenstersignals auf der Grundlage des Phasenregelkreis-Wobbelsignals;
Bestimmen der verriegelten Wobbelbedingung **durch** Zählen der Anzahl von aufeinanderfolgenden Malen, die das Wobbelsignal während des Wobbelfensterzeitraums detektiert wird, und
Generieren eines Defektdetektionssignals, wenn das Vorhandensein des Wobbelsignals während des Wobbelfenstersignals in einem verriegelten Wobbelzustand eine zuvor festgelegte Defektentscheidungsbedingung erfüllt, wobei die zuvor festgelegte Defektentscheidungsbedingung unter Berücksichtigung einer Anzahl von Nichtdetektionen eines Wobbelsignals während des Wobbelfensterzeitraums in dem verriegelten Wobbelzustand eingestellt wird.

## Revendications

1. Appareil de détection d'un défaut dans un signal d'oscillation obtenu à partir d'un motif d'oscillation présent dans une région frontière d'une zone plane et d'un sillon dans un support d'enregistrement optique, l'appareil comprenant :
une boucle verrouillée en phase (101) conçue pour recevoir le signal d'oscillation et générer et fournir en sortie un signal d'horloge d'oscillation ;
un détecteur de verrouillage/déverrouillage d'oscillation (105) conçu pour recevoir le signal d'oscillation et pour fournir en sortie un signal détectant un état déverrouillé ; et
un détecteur de défaut d'oscillation (107) conçu pour recevoir le signal détectant l'état d'oscillation déverrouillé et pour détecter s'il existe un défaut ;
dans lequel la boucle verrouillée en phase (101) est en outre conçue pour générer un signal d'oscillation de boucle verrouillée en phase par division en fréquence du signal d'horloge d'oscillation ;
dans lequel un générateur de signal de fenêtre (103) est conçu pour recevoir le signal d'horloge d'oscillation et pour générer un signal de fenêtre d'oscillation ayant une largeur réglée conformément à une condition de largeur de fenêtre prédéterminée,
ladite condition de largeur de fenêtre définissant une période de fenêtre d'oscillation en fonction d'un nombre de signaux d'horloge d'oscillation ; et
dans lequel le détecteur de verrouillage/déverrouillage d'oscillation (105) est en outre conçu pour recevoir le signal de fenêtre d'oscillation et pour fournir en sortie un signal détectant l'un d'états d'oscillation verrouillé et déverrouillé selon des conditions prédéterminées d'oscillation verrouillée et
déverrouillée, dans lequel la condition d'oscillation déverrouillée est réglée en comptant le nombre d'instants consécutifs où aucun signal d'oscillation n'est détecté pendant la période de fenêtre d'oscillation ;
**caractérisé en ce que**
la boucle verrouillée en phase (101) est conçue pour fournir en sortie le signal d'oscillation de boucle verrouillée en phase ;
le générateur de signal de fenêtre (103) est conçu pour recevoir le signal d'oscillation de boucle verrouillée en phase afin de générer le signal de fenêtre d'oscillation sur la base du signal d'oscillation de boucle verrouillée en phase ;
le détecteur de verrouillage/déverrouillage d'oscillation (105) détermine la condition d'oscillation verrouillée en comptant le nombre d'instants consécutifs où le signal d'oscillation est détecté pendant la période de fenêtre d'oscillation, et
le détecteur de défaut d'oscillation (107) est conçu pour recevoir le signal de fenêtre d'oscillation et le signal d'oscillation afin de détecter s'il existe un défaut dans le motif d'oscillation selon une condition de décision de défaut prédéterminée, dans lequel la condition de décision de défaut prédéterminée est réglée en tenant compte d'un nombre de non-détections d'un signal d'oscillation pendant la période de fenêtre d'oscillation dans l'état d'oscillation verrouillé.

2. Appareil selon l'une quelconque des revendications précédentes, dans lequel le détecteur de défaut d'oscillation (107) détecte si le défaut existe pour chaque bloc ou secteur.

3. Appareil selon l'une quelconque des revendications précédentes, dans lequel le détecteur de verrouillage/déverrouillage d'oscillation (105) comprend :
un premier compteur (401) apte à compter le nombre de signaux de fenêtre d'oscillation si le signal d'oscillation n'est pas présent pendant la période de fenêtre d'oscillation et à être réinitialisé ou mis à zéro si aucun signal d'oscillation n'existe pendant la même période ;
un premier comparateur (403) apte à comparer le résultat du comptage provenant du premier compteur à la condition d'oscillation verrouillée et à demander une condition d'oscillation verrouillée si le résultat compté respecte la condition d'oscillation verrouillée ;
un deuxième compteur (402) apte à compter le nombre des signaux de fenêtre d'oscillation si aucun signal d'oscillation n'est présent pendant la période de fenêtre d'oscillation et à être réinitialisé ou mis à zéro si le signal d'oscillation existe pendant le même intervalle ; et
un deuxième comparateur (404) apte à comparer le résultat de comptage provenant du deuxième compteur à la condition d'oscillation déverrouillée et à demander un état d'oscillation déverrouillé si le résultat compté respecte la condition d'oscillation déverrouillée ; et
un générateur de signal de verrouillage/déverrouillage d'oscillation (405) apte à fournir en sortie un signal indiquant l'état d'oscillation verrouillé/déverrouillé selon les sorties des premier et deuxième comparateurs.

4. Appareil selon l'une quelconque des revendications précédentes, dans lequel le détecteur de défaut d'oscillation comprend :
un troisième compteur (501) apte à compter le nombre des signaux de fenêtre d'oscillation si aucun signal d'oscillation n'est présent pendant la période de fenêtre d'oscillation dans un état d'oscillation verrouillé ; et
un troisième comparateur (502) apte à comparer une valeur de comptage fournie en sortie par le troisième compteur à la condition de décision de défaut prédéterminée et à fournir en sortie un signal indiquant une détection de défaut si la valeur de comptage respecte la condition de décision de défaut.

5. Procédé de détection d'un défaut dans un signal d'oscillation obtenu à partir d'un motif d'oscillation présent dans une région frontière d'une zone plane et d'un sillon dans un support d'enregistrement optique, le procédé comprenant :
le verrouillage en phase du signal d'oscillation dans une boucle verrouillée en phase et la génération d'un signal d'horloge d'oscillation ;
la détection d'un état d'oscillation verrouillé ou
déverrouillé selon des conditions d'oscillation déverrouillées prédéterminées ; et
la génération d'un signal de détection de défaut ;
la génération d'un signal d'oscillation de boucle verrouillée en phase par division en fréquence du signal d'horloge d'oscillation ;
l'utilisation du signal d'horloge d'oscillation pour générer un signal de fenêtre d'oscillation ayant une largeur réglée en fonction d'une condition de largeur de fenêtre prédéterminée, ladite condition de largeur de fenêtre définissant une période de fenêtre d'oscillation en fonction d'un nombre de signaux d'horloge d'oscillation ;
la détection d'un état d'oscillation déverrouillé selon la présence d'un signal d'oscillation pendant une période de fenêtre d'oscillation réglée par le signal de fenêtre d'oscillation, dans lequel la condition d'oscillation déverrouillée est réglée en comptant le nombre d'instants consécutifs où aucun signal d'oscillation n'est détecté pendant la période de fenêtre d'oscillation ; et
**caractérisé par** :
la génération du signal de fenêtre d'oscillation sur la base du signal d'oscillation de boucle verrouillée en phase ;
la détermination de la condition d'oscillation verrouillée en comptant le nombre d'instants consécutifs où le signal d'oscillation est détecté pendant la période de fenêtre d'oscillation, et
la génération d'un signal de détection de défaut lorsque la présence du signal d'oscillation pendant le signal de fenêtre d'oscillation dans un état d'oscillation verrouillé respecte une condition de décision de défaut prédéterminée, dans lequel la condition de décision de défaut prédéterminée est réglée en tenant compte d'un nombre de non-détections d'un signal d'oscillation pendant la période de fenêtre d'oscillation dans l'état d'oscillation verrouillé.
